# EUROPÄISCHE PATENTSCHRIFT

(11) **EP 2 567 853 B1**
(45) Veröffentlichungstag und Bekanntmachung des Hinweises auf die Patenterteilung: **21.02.2018**
(21) Anmeldenummer: 12171626.0
(22) Anmeldetag: 12.06.2012
(51) Int. Cl.: B60K 37/02, H05K 1/18, G01D 11/24

(54) **Halterungselement zur Befestigung eines Elektromotors auf einer elektronischen Leiterplatte, Anzeigeeinrichtung eines Kraftfahrzeugs umfassend ein elektrisches Zeigerinstrument mit einem mittels eines solchen Halterungselements auf einer elektronischen Leiterplatte befestigten Elektromotors sowie Verfahren zur Befestigung eines Elektromotors auf einer elektronischen Leiterplatte mittels eines solchen Halterungselements**
Holder element for fixing an electric motor to an electronic circuit board, display device of a motor vehicle comprising an electrical display instrument with an electric motor fixed to an electronic circuit board by means of such a holder element and method for fixing an electric engine to an electronic circuit board by means of such a holder element
Élément de fixation pour un moteur électrique sur une plaquette électronique, dispositif d'affichage d'un véhicule automobile comprenant un instrument à aiguille électrique avec moteur électrique fixé sur une plaquette électronique au moyen d'un tel élément de fixation ainsi que le procédé de fixation d'un moteur électrique sur une plaquette électronique avec un tel élément de fixation

(30) Priorität: 07.09.2011 DE 102011082272
(43) Veröffentlichungstag der Anmeldung: 13.03.2013
(73) Patentinhaber: Magneti Marelli GmbH, 65428 Rüsselsheim (DE)
(72) Erfinder: Mayr, Stefan, 70567 Stuttgart (DE)
(74) Vertreter: DREISS Patentanwälte PartG mbB

(56) Entgegenhaltungen:
- EP-A2- 0 420 650
- DE-A1- 4 209 823
- DE-A1- 19 529 122
- DE-A1- 19 632 381
- US-A1- 2005 012 607

## Beschreibung

Die vorliegende Erfindung betrifft ein Halterungselement zur Befestigung eines Elektromotors auf einer elektronischen Leiterplatte eines elektrischen Zeigerinstruments, wobei der Elektromotor über eine Motorwelle einen Zeiger des Zeigerinstruments antreibt. Ferner betrifft die Erfindung eine Anzeigeeinrichtung eines Kraftfahrzeugs umfassend mindestens ein elektrisches Zeigerinstrument mit mindestens einem durch einen Elektromotor angetriebenen Zeiger, wobei der Elektromotor auf einer elektronischen Leiterplatte befestigt und über diese elektrisch kontaktiert ist und eine Motorwelle aufweist, an der der mindestens eine Zeiger des mindestens einen Zeigerinstruments befestigt ist. Schließlich betrifft die vorliegende Erfindung auch ein Verfahren zur Befestigung eines Elektromotors auf einer elektronischen Leiterplatte eines elektrischen Zeigerinstruments, wobei der Elektromotor über eine Motorwelle einen Zeiger des Zeigerinstruments antreibt, wobei der Elektromotor von hinten in das Halterungselement einsetzbar ist. Aus dem Stand der Technik sind verschiedene Anzeigeeinrichtungen für Kraftfahrzeuge bekannt, bspw. in Form eines für den Einsatz in einem Kraftfahrzeug vorgesehenen Kombiinstruments zur gleichzeitigen Anzeige verschiedener betriebs- oder verkehrsbezogener Daten des Kraftfahrzeugs bzw. seines Umfelds, wie es bspw. aus der DE 103 31 131 A1 bekannt ist. Solche Anzeigeeinrichtungen weisen mindestens ein Zeigerinstrument auf, das mindestens einen jeweils durch einen Elektromotor angetriebenen Zeiger umfasst. Das Zeigerinstrument verfügt ferner über eine mit einer Skala versehene Anzeigefläche, wobei vorzugsweise jedem Zeiger eines Zeigerinstruments eine eigene Skala zugeordnet ist. Derartige Zeigerinstrumente werden auch als Analoginstrumente bezeichnet. Die Zeigerinstrumente dienen in Kraftfahrzeugen bspw. zur Anzeige der aktuellen Fahrzeuggeschwindigkeit (Tachometer), der aktuellen Motordrehzahl (Drehzahlmesser), des Tankinhalts, der Batteriespannung, des Ladedrucks eines Turboladers oder Kompressors, der Öltemperatur, des Öldrucks, der Außentemperatur, der Kühlwassertemperatur etc.

Bei Verwendung mehrerer neben- und/oder übereinander angeordneter Zeigerinstrumente in einer Anzeigerichtung sind die einzelnen Zeigerinstrumente bzw. deren Anzeigeflächen häufig um die Position des Fahrers herum jeweils zum Fahrer hin gerichtet angeordnet, sodass sich ein um den Fahrer herum gewölbtes Kombiinstrument ergibt. Aus Gründen einer einfacheren und kostengünstigeren Fertigung wird in der Regel versucht, die elektronische Schaltung einschließlich aller elektrischer und elektronischer Bauteile und der Elektromotoren zum Antrieb der Zeiger sämtlicher Zeigerinstrumente einer Anzeigevorrichtung auf einer einzigen elektronischen Leiterplatte anzuordnen.

Bei schräg zueinander angeordneten Anzeigeflächen der einzelnen Zeigerinstrumente ist dies im Stand der Technik jedoch nicht möglich. Nach dem Stand der Technik können immer nur diejenigen Elektromotoren auf einer gemeinsamen elektronischen Leiterplatte angeordnet werden, die Zeigerinstrumenten zugeordnet sind, deren Anzeigeflächen auf einer einzigen Ebene oder zumindest auf zueinander parallelen Ebenen angeordnet sind. Elektromotoren, die Zeigerinstrumenten zugeordnet sind, deren Anzeigeflächen schräg zu den Anzeigeflächen der übrigen Zeigerinstrumente angeordnet sind, müssen nach dem Stand der Technik immer auf eigenen, separaten Leiterplatten angeordnet werden. Der Grund hierfür besteht darin, dass versucht wird, Elektromotoren von Zeigerinstrumenten von Anzeigeeinrichtungen immer derart auf den elektronischen Leiterplatten zu befestigen, dass die Motorwellen der Elektromotoren senkrecht zur Flächenerstreckung der Anzeigeflächen verlaufen. Nur so kann auf den Einsatz eines aufwendigen und teuren Gelenks zwischen der Motorwelle und einer senkrecht zur Anzeigefläche angeordneten Zeigerwelle verzichtet werden. Eine entsprechende Befestigung eines Elektromotors auf einer Leiterplatte mittels eines Halterungselements ist bspw. aus der DE 42 09 823 A1 oder der CN 2725083 Y bekannt.

Es wäre theoretisch denkbar, die Elektromotoren aller Zeigerinstrumente einer Anzeigeeinrichtung auf einer einzigen flexiblen Leiterplatte anzuordnen und diese dann gewölbt in die Anzeigeeinrichtung einzubauen, sodass die Motorwellen sämtlicher Elektromotoren jeweils senkrecht zu den Anzeigeflächen der ihnen zugeordneten Zeigerelemente verlaufen. Dadurch könnten zwar sämtliche Elektromotoren auf einer einzigen Leiterplatte befestigt werden. Die Flexibilität der Leiterplatte würde jedoch zu erheblichen Problemen bei der Bestückung sowie der Handhabung während der Montage in der Anzeigeeinrichtung führen, sodass die Verwendung einer flexiblen Leiterplatte in der Praxis nicht in Betracht gezogen wird.

Aus der DE 196 32 381 A1 ist ein Kombinationsinstrument mit einer in einen Frontrahmen einrastbaren Platine mit darauf abgestützten Halteteilen mit den Merkmalen des Oberbegriffs des Anspruchs 1 bekannt. Die DE 42 09 823 A1 zeigt einen Schrittmotor, der ein Motorgehäuse und ein mit dem Motorgehäuse verrastbares Kupplungsteil aufweist, wobei das Kupplungsteil integraler Bestandteil einer Leiterplatte ist. Weitere Anzeigeinstrumente sind aus der US 2005/0012607 A1, der EP 0 420 650 A2 und der DE 195 29 122 A1 bekannt. Ausgehend von dem beschriebenen Stand der Technik liegt der vorliegenden Erfindung die Aufgabe zu Grunde, bei gewölbten Anzeigeeinrichtungen, bei denen die Anzeigeflächen der einzelnen Zeigerinstrumente zumindest zum Teil schräg zueinander angeordnet sind, sämtliche Elektromotoren zur Betätigung der Zeiger der Zeigerinstrumente auf einer einzigen ebenen starren elektronischen Leiterplatte sicher anzuordnen.
Zur Lösung dieser Aufgabe wird ausgehend von dem Halterungselement der eingangs genannten Art vorgeschlagen, dass das Halterungselement erste Befestigungsmittel zur Befestigung des Halterungselements auf der Leiterplatte und zweite Befestigungsmittel zur Befestigung des Elektromotors an dem Halterungselement aufweist, wobei die ersten und die zweiten Befestigungsmittel des Halterungselements derart ausgebildet und relativ zueinander angeordnet sind, dass der Elektromotor mit sich schräg zu einer Flächenerstreckung der Leiterplatte erstreckender Motorwelle auf der Leiterplatte befestigt ist.
Erfindungsgemäß wird also vorgeschlagen, das Halterungselement, mit dem der Elektromotor auf der elektronischen Leiterplatte oder Platine befestigt und elektrisch kontaktiert wird, derart auszugestalten, dass eine schräge Befestigung des Elektromotors auf der Leiterplatte möglich ist. Dabei wird das Halterungselement je nach gewünschtem Winkel der Schrägstellung des Elektromotors relativ zur Leiterplatte ausgestaltet. Durch Befestigen des Halterungselements auf der Leiterplatte in einer bestimmten Drehstellung um eine senkrecht zur Leiterplatte verlaufenden imaginären Drehachse kann die Richtung der Schrägstellung bzw. die Ausrichtung der Motorwelle bezüglich der Leiterplatte festgelegt werden. Gleichartige Halterungselemente können um die imaginäre Drehachse um 180° zueinander gedreht auf der Leiterplatte befestigt werden. Dadurch kann bspw. zum einem ein erster Elektromotor mit nach rechts geneigter Motorwelle und zum anderen ein anderer Elektromotor mit nach links geneigter Motorwelle auf der Leiterplatte befestigt werden. Für unterschiedliche Neigungswinkel des Elektromotors relativ zu der Leiterplatte werden unterschiedliche Halterungselemente vorgesehen.

Die Anordnung aller Elektromotoren auf einer einzigen, ebenen, starren Leiterplatte gilt nicht nur während der Montage und Bestückung der Leiterplatte, sondern auch dann, wenn die bestückte Leiterplatte in einer betriebsbereiten Position in der Anzeigeeinrichtung eingebaut ist und sich die Anzeigeeinrichtung in einem betriebsbereiten Zustand befindet.

Die Halterungselemente werden zusammen mit den übrigen elektrischen und elektronischen Bauelementen im Rahmen der Bestückung der Leiterplatte auf dieser angeordnet und bspw. im Rahmen eines Lötprozesses, insbesondere eines Reflow-Lötprozesses, auf dieser befestigt und elektrisch kontaktiert. Anschließend können die Elektromotoren an den Halterungselementen befestigt werden. Dabei werden die Elektromotoren vorzugsweise gleichzeitig mit der Befestigung in den Halterungselementen auch elektrisch kontaktiert. Auf diese Weise können die Elektromotoren in einem einzigen Schritt einerseits an den Halterungselementen mechanisch befestigt und gleichzeitig elektrisch kontaktiert werden.

Die vorliegende Erfindung erlaubt eine Montage der Elektromotoren schräg zur Flächenerstreckung der elektronischen Leiterplatte. Dadurch ist es erstmals möglich, bei gewölbten Anzeigeeinrichtungen mit mehreren relativ zueinander geneigten Zeigerinstrumenten bzw. zueinander geneigten skalierten Anzeigeflächen der Zeigerinstrumente die den Zeigerinstrumenten zugeordneten Elektromotoren auf einer einzigen gemeinsamen, ebenen, starren Leiterplatte zu befestigen. Das hat erhebliche Vorteile sowohl bei der Bestückung der Leiterplatte als auch bei der Montage der Anzeigeeinrichtung, insbesondere beim Einsetzen der bestückten Leiterplatte mit den darauf befestigten und elektrisch kontaktierten Bauteilen. Mit der vorliegenden Erfindung können gewölbte Anzeigeeinrichtungen eines Kraftfahrzeugs einfach und kostengünstig realisiert werden, wobei gleichzeitig der Herstellungsaufwand deutlich reduziert wird.

Gemäß einer vorteilhaften Weiterbildung der vorliegenden Erfindung wird vorgeschlagen, dass die ersten Befestigungsmittel derart ausgebildet sind, dass sie eine Befestigung des Halterungselements auf der Leiterplatte mittels eines Lötprozesses, insbesondere eines Reflow-Lötprozesses, erlauben. Zu diesem Zweck weist das Halterungselement vorzugsweise Kontaktelemente auf, die bei auf der Leiterplatte angeordnetem Halterungselement mit entsprechenden Kontaktierungsmitteln der Leiterplatte in Eingriff treten und zumindest im Anschluss an den Lötprozess für eine elektrische Kontaktierung des Halterungselements sorgen. Die Kontaktelemente können bspw. als Steckkontaktelemente oder als Federkontaktelemente ausgebildet sein. Dementsprechend können die Kontaktierungsmittel als in der Leiterplatte ausgebildete Kontaktierungslöcher oder auf der Leiterplatte ausgebildete Kontaktierungsflächen ausgebildet sein. Vorzugsweise werden die Steckkontaktelemente mit Kontaktierungslöchern und die Federkontaktelemente mit Kontaktierungsflächen eingesetzt.

Vorzugsweise sind die Kontaktierungsmittel der Leiterplatte als Kontaktierungslöcher ausgebildet, welche als Steckkontaktelemente ausgebildete Kontaktelemente des Halterungselements bei auf der Leiterplatte angeordnetem Halterungselement aufnehmen, sodass die Steckkontaktelemente des Halterungselements mittels des Lötprozesses, insbesondere des Reflow-Lötprozesses, in den Kontaktierungslöchern der Leiterplatte kontaktierbar und befestigbar sind. Alternativ können die Kontaktierungsmittel der Leiterplatte auch als Kontaktierungsflächen ausgebildet sein, welche als Federkontaktelemente ausgebildete Kontaktelemente des Halterungselements bei auf der Leiterplatte angeordnetem Halterungselement aufnehmen, sodass die Federkontaktelemente des Halterungselements mittels des Lötprozesses, insbesondere des Reflow-Lötprozesses, auf den Kontaktierungsflächen der Leiterplatte kontaktierbar und befestigbar sind. Dabei nehmen die Kontaktierungsmittel der Leiterplatte bei auf der Leiterplatte angeordnetem Halterungselement die (Flächen- oder Steck-) Kontaktelemente des Halterungselements vorzugsweise automatisch bzw. zwangsläufig auf, so dass es keines zusätzlichen Arbeitsschrittes zur Herstellung des elektrischen Kontakts bedarf.

Besonders bevorzugt ist dabei, wenn dadurch nicht nur eine elektrische Kontaktierung der Kontaktelemente des Halterungselements erfolgt, sondern gleichzeitig auch das Halterungselement auf der Leiterplatte mechanisch befestigt wird. Damit wird das Halterungselement vorteilhaft in entsprechender Weise wie andere elektronische und elektrische Bauteile und Komponenten ebenfalls im Rahmen eines Reflow-Lötprozesses auf der elektronischen Leiterplatte kontaktiert und befestigt.

Gemäß einer weiteren bevorzugten Ausführungsform der vorliegenden Erfindung wird vorgeschlagen, dass die zweiten Befestigungsmittel derart ausgebildet sind, dass sie eine lösbare Befestigung des Elektromotors an dem Halterungselement erlauben. Die zweiten Befestigungsmittel sind vorteilhafterweise derart ausgebildet, dass sie eine Befestigung des Elektromotors an dem Halterungselement mittels einer Schnapp- oder Rastverbindung erlauben. Dadurch kann der Elektromotor im Anschluss an den Lötprozess, insbesondere den Reflow-Lötprozess, schnell und einfach an dem Halterungselement befestigt werden. Eine zeitsparende und kostengünstige automatisierte Montage der Elektromotoren in großen Stückzahlen ist dadurch möglich.

Gemäß einer anderen vorteilhaften Weiterbildung der Erfindung wird vorgeschlagen, dass das Halterungselement Kontaktelemente aufweist, die derart ausgebildet und angeordnet sind, dass sie bei an dem Halterungselement befestigtem Elektromotor mit korrespondierenden Kontaktelementen des Elektromotors in Eingriff treten und für eine elektrische Kontaktierung des Elektromotors sorgen. Die Kontaktelemente des Halterungselements sind über die Leiterplatte elektrisch kontaktiert, bspw. mittels des beschriebenen Lötprozesses, insbesondere des Reflow-Lötprozesses. Die Kontaktelemente des Halterungselements sind bspw. als Steck-, Feder- oder Flächenkontaktelemente ausgebildet. Die korrespondierenden Kontaktelemente des Elektromotors sind dementsprechend bspw. als Steck-, Flächen- oder Federkontaktelemente ausgebildet.

Vorzugsweise sind die Kontaktelemente von Halterungselement und Elektromotor als Steckkontaktelemente ausgebildet, wobei die Steckkontaktelemente des Halterungselements als Buchsenkontaktelemente ausgebildet sind, mit denen die als Stiftkontaktelemente ausgebildeten korrespondierenden Steckkontaktelemente des Elektromotors in Eingriff treten, wenn der Elektromotor in das Halterungselement eingesetzt ist. Demnach wird also der Elektromotor gleichzeitig mit der Befestigung an dem Halterungselement auch elektrisch kontaktiert, indem die Stiftkontaktelemente des Elektromotors in die korrespondierenden Buchsenkontaktelemente des Halterungselements eintreten, wo automatisch ein elektrischer Kontakt zwischen den Buchsenkontaktelementen und den Stiftkontaktelementen hergestellt wird. Dies erlaubt eine besonders einfache und zeiteffiziente Befestigung und Kontaktierung des Elektromotors an dem Halterungselement.

Selbstverständlich ist es auch denkbar, dass die Buchsenkontaktelemente an dem Elektromotor und die korrespondierenden Stiftkontaktelemente an dem Halterungselement ausgebildet sind oder dass der Elektromotor nicht lösbar an dem Halterungselement befestigt wird. Ebenso wäre es denkbar, dass das Halterungselement Teil eines Gehäuses des Elektromotors, also ein integraler Bestandteil des Elektromotorgehäuses ist. In diesem Fall müsste entweder der Elektromotor den thermischen Belastungen des Reflow-Lötprozesses standhalten können oder die Elektromotor-Halterungselement-Kombination wird erst im Anschluss an den Reflow-Lötprozess auf der elektronischen Leiterplatte befestigt und elektrisch kontaktiert, bspw. mittels eines beliebig anderen Lötprozesses. Selbst wenn das Halterungselement integraler Bestandteil des Motorgehäuses ist, erlaubt es aufgrund der erfindungsgemäßen Ausgestaltung eine schräge Montage des Elektromotors auf der elektronischen Leiterplatte.

Gegenstand der vorliegenden Erfindung ist auch eine Anzeigeeinrichtung eines Kraftfahrzeugs der eingangs genannten Art, wobei der Elektromotor mittels eines Halterungselements derart auf der elektronischen Leiterplatte befestigt ist, dass sich die Motorwelle schräg zu einer Flächenerstreckung der Leiterplatte erstreckt. Vorzugsweise ist das Halterungselement als separates Bauteil getrennt von einem Gehäuse des Elektromotors ausgebildet. Ganz besonders vorteilhaft ist eine Anzeigeeinrichtung, bei der der Elektromotor mittels eines erfindungsgemäßen Halterungselements auf der Leiterplatte befestigt und ggf. elektrisch kontaktiert ist.

Schließlich betrifft die vorliegende Erfindung auch ein Verfahren zur Befestigung eines Elektromotors auf einer elektronischen Leiterplatte der eingangs genannten Art, wobei zunächst ein Halterungselement über erste Befestigungsmittel des Halterungselements auf der Leiterplatte befestigt wird und anschließend der Elektromotor über zweite Befestigungsmittel des Halterungselements an dem Halterungselement befestigt wird, wobei die ersten und zweiten Befestigungsmittel des Halterungselements derart ausgebildet und relativ zueinander angeordnet sind, dass der Elektromotor mit sich schräg zu einer Flächenerstreckung der Leiterplatte erstreckender Motorwelle auf der Leiterplatte befestigt wird, wobei der Elektromotor von hinten in das Halterungselement eingesetzt wird. Weitere Merkmale und Vorteile der vorliegenden Erfindung werden nachfolgend unter Bezugnahme auf die Figuren näher erläutert. Es wird darauf hingewiesen, dass die vorliegenden Erfindung die angegebenen Merkmale und Vorteile nicht nur in der beschriebenen Kombination, sondern auch in Alleinstellung oder einer beliebig anderen Kombination aufweisen kann. Dabei zeigen:
- Figur 1: eine perspektivische Ansicht einer erfindungsgemäßen Einrichtung gemäß einem ersten bevorzugten Ausführungsbeispiel;
- Figur 2: eine Schnittansicht von oben auf eine erfindungsgemäße Anzeigeeinrichtung gemäß einem weiteren bevorzugten Ausführungsbeispiel; und
- Figur 3: ein erfindungsgemäßes Halterungselement gemäß einer bevorzugten Ausführungsform in vergrößerter Darstellung.

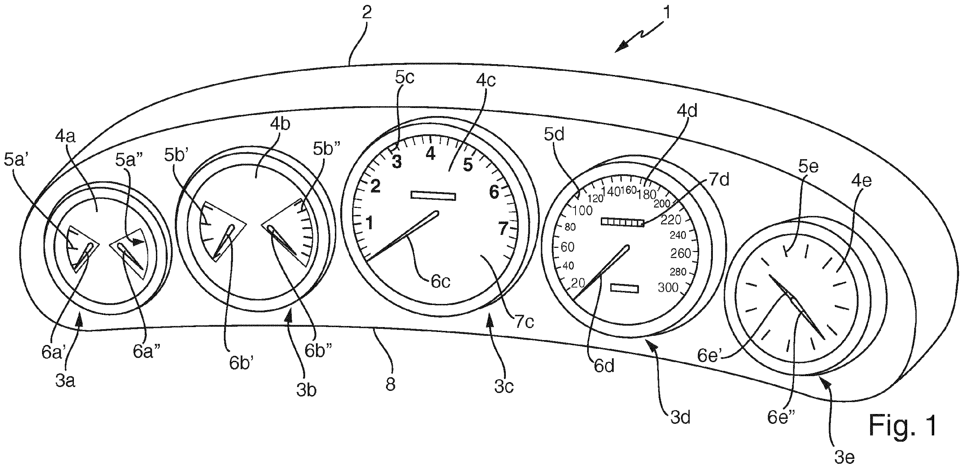

In Figur 1 ist eine erfindungsgemäße Anzeigeeinrichtung in ihrer Gesamtheit mit dem Bezugszeichen 1 bezeichnet. Die Anzeigeeinrichtung 1 wird auch als Kombiinstrument bezeichnet. Sie weist ein Gehäuse oder Tragelement 2 auf, in bzw. an dem mehrere Zeigerinstrumente 3 befestigt sind. Die in Figur 1 beispielhaft gezeigte Anzeigeeinrichtung 1 umfasst fünf nebeneinander angeordnete Zeigerinstrumente 3a bis 3e. Selbstverständlich kann die erfindungsgemäße Anzeigeeinrichtung 1 auch mehr oder weniger als die dargestellten fünf Zeigerinstrumente 3a bis 3e aufweisen.

Ferner ist es denkbar, dass die Zeigerinstrumente 3a bis 3e nicht in der dargestellten Weise, sondern auf andere Weise nebeneinander und/oder übereinander und/oder versetzt zueinander in der Anzeigeeinrichtung 1 angeordnet sind. Ferner ist es denkbar, dass eines oder mehrere der Zeigerinstrumente 3a bis 3e durch ein digitales multifunktionales Instrument, bspw. in Form einer LCD- oder LED-Anzeige (sogenanntes Display), ersetzt ist.

Bei dem in Figur 1 gezeigten Ausführungsbeispiel der Anzeigeeinrichtung 1 weist das linke Zeigerinstrument 3a eine Anzeigefläche 4a auf, auf der links eine erste Skala 5a' bspw. für den Tankinhalt und rechts (nicht sichtbar) eine zweite Skala 5a" bspw. für die Batteriespannung angeordnet ist. Der ersten Skala 5a' ist ein erster Zeiger 6a' und der zweiten Skala 5a" ein zweiter Zeiger 6a" zugeordnet.

In entsprechender Weise verfügt das Zeigerinstrument 3b über eine ebene Anzeigefläche 4b, auf der links eine erste Skala 5b' bspw. für die Kühlwassertemperatur und rechts eine zweite Skala 5b" bspw. für den Öldruck aufgebracht ist. Der ersten Skala 5b' ist ein erster Zeiger 6b' und der zweiten Skala 5b" ein zweiter Zeiger 6b" zugeordnet.

In entsprechender Weise weist das Zeigerinstrument 3c eine ebene Anzeigefläche 4c auf, die mit einer Skala 5c bspw. für die aktuelle Motordrehzahl versehen ist. Der Skala 5c ist ein Zeiger 6c zugeordnet. Ferner ist auf der Anzeigefläche 4c eine LCD-, LED- oder beliebig andere Anzeige angeordnet, auf der bspw. die aktuelle Fahrzeuggeschwindigkeit in digitaler Form angezeigt werden kann.

Das Zeigerinstrument 3d verfügt ebenfalls über eine ebene Anzeigefläche 4d, auf der eine Skala 5d bspw. für die aktuelle Fahrzeuggeschwindigkeit angeordnet ist. Der Skala 5d ist ein Zeiger 6d zugeordnet. Ferner ist auf der Anzeigefläche 4d eine mechanische oder elektronische Anzeige 7d vorgesehen, um die zurückgelegte Fahrtstrecke anzuzeigen.

Schließlich weist das rechte Zeigerinstrument 3e eine ebene Anzeigefläche 4e auf, auf der eine Skala 5e bspw. für die aktuelle Uhrzeit ausgebildet ist. Der Skala 5e sind zwei Zeiger 6e' und 6e" zugeordnet, die zur Anzeige der aktuellen Stunden und Minuten vorgesehen sind.

Auf sämtlichen Anzeigefläche 4a bis 4e können beliebig ausgebildete Kontrollleuchtelemente, bspw. zur Anzeige eines eingeschalteten Fahrtlichtes, eines eingeschalteten Fernlichtes, eines aktivierten Blinklichts oder einer beliebigen Notfallsituation des Kraftfahrzeugs und/oder des Motors, ausgebildet sein, die in Figur 1 jedoch nicht explizit gezeigt sind.

Jeder einzelne der Zeiger 6a', 6a", 6b', 6b", 6c, 6d, 6e', 6e" wird durch einen eigenen separaten Elektromotor, der vorzugsweise als ein Schrittmotor ausgebildet ist, angetrieben bzw. betätigt. In Figur 1 ist gut zu erkennen, dass die Anzeigeeinrichtung 1 eine um den Fahrer gewölbte Form aufweist, d.h. die verschiedenen Zeigerinstrumente 3a bis 3e bzw. die Anzeigeflächen 4a bis 4e sind zum Betrachter hin gerichtet, sodass zumindest die äußeren Zeigerinstrumente 3a und 3e schräg angeordnet sind. Bezogen auf eine durch die Anzeigefläche 4c des mittleren Zeigerinstruments 3c definierte imaginäre Ebene ist also das linke Zeigerinstrument 3a derart angeordnet, dass die Anzeigefläche 4a bezüglich der durch die Anzeigefläche 4c definierter Ebene nach rechts geneigt ist. In entsprechender Weise ist bei dem rechten Zeigerinstrument 3e die Anzeigefläche 4e bezogen auf die durch die Anzeigefläche 4c definierte Ebene nach links geneigt angeordnet. Bezogen auf die durch die Anzeigefläche 4c definierte Ebene kann auch für die Anzeigeflächen 4b und 4d der Zeigerinstrumente 3b und 3d eine Schrägstellung vorgesehen sein. Durch die Schrägstellung der einzelnen Zeigerinstrumente 3a, 3b, 3d und/oder 3e ergibt sich die gewölbte Form der Anzeigeeinrichtung 1, die durch einen bogenförmigen unteren Rand 8 des Gehäuses 2 veranschaulicht ist.

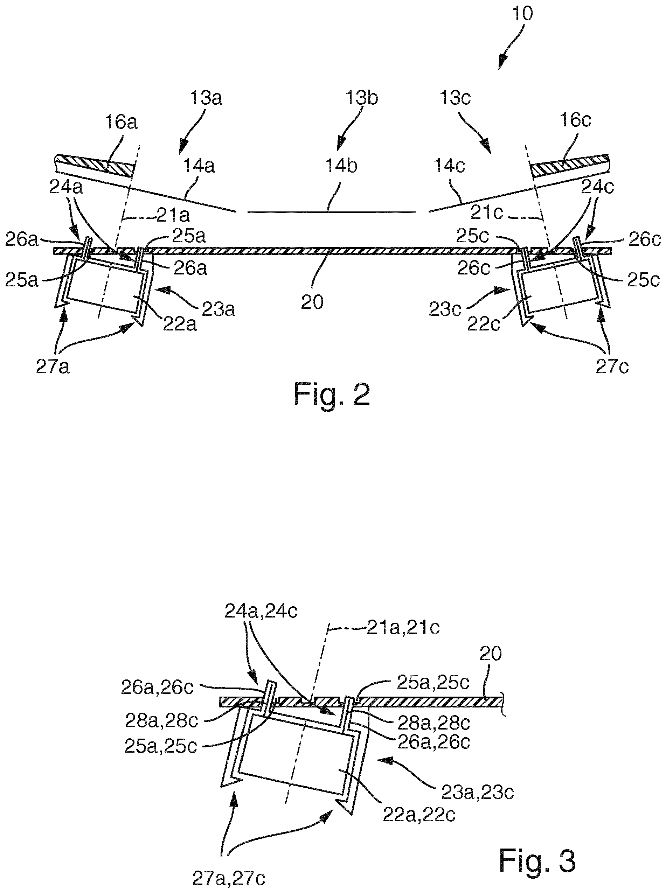

Bei derart gewölbten Anzeigeeinrichtungen 1 stellt die Befestigung der Elektromotoren zum Antrieb bzw. zur Betätigung der Zeiger 6a' bis 6e" eine Herausforderung dar. Einerseits ist eine Befestigung sämtlicher Elektromotoren auf einer einzigen gemeinsamen elektronischen Leiterplatte wünschenswert. Andererseits müssen die Elektromotoren derart angeordnet werden, dass ihre Motorwellen jeweils senkrecht zur Flächenerstreckung der Anzeigeflächen 4a bis 4e der den Motoren jeweils zugeordneten Zeigerinstrumente 3a bis 3e verlaufen. Diesbezüglich bietet die vorliegenden Erfindung einen besonders vorteilhaften Lösungsansatz, der nachfolgend unter Bezugnahme auf die Figur 2 näher erläutert wird.

Figur 2 zeigt eine Schnittansicht von oben durch eine erfindungsgemäße Anzeigeeinrichtung 10 gemäß einer anderen bevorzugten Ausführungsform. Das Gehäuse oder das Tragelement der Anzeigeeinrichtung 10 wurde in Figur 2 nicht eingezeichnet. Die Anzeigeeinrichtung 10 aus Figur 2 umfasst lediglich drei Zeigerelemente 13a, 13b und 13c. Selbstverständlich ist es auch denkbar, dass die Anzeigeeinrichtung 10 auch mehr oder weniger als drei Zeigerinstrumente aufweist. Bspw. das mittlere Zeigerinstrument 13b könnte auch durch eine LCD-, LED- oder beliebig andere Anzeigeeinrichtung sein.

Die Zeigerinstrumente 13a bis 13c weisen jeweils eine ebene Anzeigefläche 14a, 14b, 14c auf. Dabei verläuft die Anzeigefläche 14b des mittleren Zeigerinstruments 13b im Wesentlichen parallel zu einer dahinter angeordneten elektronischen Leiterplatte 20. Die Anzeigeflächen 14a und 14c der äußeren Zeigerinstrumente 13a und 13c sind dagegen in einem bestimmten Winkel schräg zu der Leiterplatte 20 angeordnet. Durch die gezeigte Anordnung der Anzeigeflächen 14a bis 14c ergibt sich auch für die Anzeigeeinrichtung 10 aus Figur 2 eine gewölbte Form, die in der Draufsicht besonders gut zu erkennen ist.

Auf den Anzeigeflächen 14a bis 14c sind eine oder mehrere Skalen aufgebracht, die in Figur 2 nicht eingezeichnet sind. Den Skalen ist jeweils mindestens ein Zeiger 16a und 16c zugeordnet, wobei der der Skala des mittleren Zeigerinstruments 13b zugeordnete Zeiger nicht eingezeichnet ist. Jeder Zeiger 16a, 16c wird über eine Motorwelle 21a, 21c durch einen Elektromotor 22a, 22c angetrieben, der vorzugsweise als ein Schrittmotor ausgebildet ist. Die Zeiger 16a, 16c sind also drehfest an den Wellen 21a, 21c befestigt. Auf der elektronischen Leiterplatte 20 sind elektrische und/oder elektronische Bauelemente sowie Leiterbahnen ausgebildet, die zusammen eine Ansteuerschaltung für die Anzeigeeinrichtung 10 bilden können.

Aufgrund der Schrägstellung der Anzeigeflächen 14a, 14c der äußeren Zeigerinstrumente 13a, 13c ist es vorteilhaft, die Elektromotoren 22a, 22c schräg auf der Leiterplatte 20 zu befestigen. Dies geschieht mittels eines erfindungsgemäßen Halterungselements 23a, 23c. Das erfindungsgemäße Halterungselement 23a, 23c weist erste Befestigungsmittel 24a, 24c zur Befestigung des Halterungselements 23a, 23c auf der Leiterplatte 20 auf. Die Befestigungsmittel 24a, 24c können in beliebiger Weise ausgebildet sein. Die Befestigungsmittel 24a, 24c können als beliebige Kontaktelemente, bspw. als Steckkontaktelemente oder als Federkontaktelemente ausgebildet sein. In dem dargestellten Ausführungsbeispiel umfassen die Befestigungsmittel 24a, 24c an dem Halterungselement 23a, 23c ausgebildete Buchsenkontaktelemente 26a, 26c, die in Kontaktierungslöcher 25a, 25c eingreifen, die in der Leiterplatte 20 ausgebildet sind. Insbesondere bei als Federkontaktelemente ausgebildeten Befestigungsmitteln 24a, 24c könnten statt der Kontaktierungslöcher 25a, 25c auf der Leiterplatte 20 Kontaktierungsflächen ausgebildet sein, auf denen die Federkontaktelemente bei auf der Leiterplatte 20 angeordnetem Halterungselement 23a, 23c zur Herstellung eines elektrischen Kontakts zwischen dem Halterungselement 23a, 23c und der Leiterplatte 20 aufliegen.

Die Buchsenkontaktelemente 26a, 26c des dargestellten Ausführungsbeispiels sind so lang ausgebildet, dass sie bei auf die Leiterplatte 20 aufgesetztem Halterungselement 23a, 23c in die Kontaktierungslöcher 25a, 25c der Leiterplatte 20 eindringen. Die Buchsenkontaktelemente 26a, 26c werden bspw. mittels eines beliebigen Lötprozesses, insbesondere eines Reflow-Lötprozesses, in den Kontaktierungslöchern 25a, 25c mit der auf der Leiterplatte 20 ausgebildeten Schaltung kontaktiert. Damit werden nicht nur die Buchsenkontaktelemente 26a, 26c des Halterungselements 23a, 23c elektrisch kontaktiert, sondern wird auch das Halterungselement 23a, 23c als solches auf der Leiterplatte 20 mechanisch befestigt.

Das Halterungselement 23a, 23c ist vergrößert in Figur 3 gezeigt. Es verfügt ferner über zweite Befestigungsmittel 27a, 27c zur mechanischen Befestigung des Elektromotors 22a, 22c an dem Halterungselement 23a, 23c. Die zweiten Befestigungsmittel 27a, 27c können in beliebiger Weise ausgestaltet sein. In dem dargestellten Ausführungsbeispiel sind die Befestigungsmittel 27a, 27c derart ausgebildet, dass sie eine lösbare Befestigung des Elektromotors 22a, 22c, insbesondere mittels einer Schnapp- oder Rastverbindung, erlauben. Zur Befestigung des Elektromotors 22a, 22c an dem Halterungselement 23a, 23c wird dieser einfach von hinten in das Halterungselement 23a, 23c eingesetzt, sodass Rastelemente der Befestigungsmittel 27a, 27c auseinander gebogen werden. Sobald der Elektromotor 22a, 22c vollständig in das Halterungselement 23a, 23c eingesetzt ist, schnappen die Rastelemente wieder in ihre ursprüngliche Position zurück und sichern den Elektromotor 22a, 22c in der eingesetzten Position mittels Rastnasen.

Gleichzeitig mit dem Einsetzen des Elektromotors 22a, 22c in das Halterungselement 23a, 23c treten an dem Elektromotor 22a, 22c ausgebildete Stiftkontaktelemente 28a, 28c in die Buchsenkontaktelemente 26a, 26c des Halterungselements 23a, 23c ein und werden dort elektrisch kontaktiert. Somit erfolgt die mechanische Befestigung des Elektromotors 22a, 22c in dem Halterungselement 23a, 23c sowie die elektrische Kontaktierung des Elektromotors 22a, 22c in einem Schritt. Es ist auch denkbar, dass die Kontaktierung der Stiftkontaktelemente 28a, 28c des Elektromotors 22a, 22c in den Buchsenkontaktelementen 26a, 26c derart erfolgt, dass der Elektromotor 22a, 22c dadurch auch mechanisch in dem Halterungselement 23a, 23c gehalten wird, so dass unter Umständen sogar auf die separaten zweiten Befestigungsmittel 27a, 27c verzichtet werden könnte bzw. die Buchsenkontaktelemente 26a, 26c für die Stiftkontaktelemente 28a, 28c als zweite Befestigungsmittel dienen.

Das erfindungsgemäße Halterungselement 23a, 23c ermöglicht, wie anhand der Figuren 2 und 3 ersichtlich, eine Montage und Befestigung des Elektromotors 22a, 22c schräg zu einer ebenen, starren Leiterplatte 20. Somit ist es möglich, selbst bei gewölbten Anzeigeeinrichtungen 1, 10 sämtliche Elektromotoren 22a, 22c der Zeigerinstrumente 3a bis 3e sowie 13a bis 13c auf einer einzigen, gemeinsamen, ebenen, starren Leiterplatte 20 zu befestigen und zu kontaktieren. Dies gilt nicht nur für den Prozess der Bestückung der Leiterplatte 20, sondern auch für den Prozess der Montage der Leiterplatte 20 in der Anzeigeeinrichtung 1, 10 und für die Dauer der Anordnung der Leiterplatte 20 in einem betriebsfähigen Zustand in der Anzeigeeinrichtung 1, 10. Dabei erfolgt die Befestigung und Kontaktierung der Elektromotoren 22a, 22c auf besonders einfache und effiziente Weise.

## Patentansprüche

1. Halterungselement (23a, 23c) zur Befestigung eines Elektromotors (22a, 22c) auf einer elektronischen Leiterplatte (20) eines elektrischen Zeigerinstruments (3a, 3b, 3c, 3d, 3e, 13a, 13b, 13c), wobei der Elektromotor (22a, 22c) über eine Motorwelle (21a, 21c) einen Zeiger (6a', 6a", 6b', 6b", 6c, 6d, 6e', 6e", 16a, 16c) des Zeigerinstruments (3a, 3b, 3c, 3d, 3e, 13a, 13b, 13c) antreibt, wobei das Halterungselement (23a, 23c) erste Befestigungsmittel (24a, 24c) zur Befestigung des Halterungselements (23a, 23c) auf der Leiterplatte (20) und zweite Befestigungsmittel (27a, 27c) zur Befestigung des Elektromotors (22a, 22c) an dem Halterungselement (23a, 23c) aufweist, wobei die ersten und zweiten Befestigungsmittel (24a, 24c; 27a, 27c) des Halterungselements (23a, 23c) derart ausgebildet und relativ zueinander angeordnet sind, dass der Elektromotor (22a, 22c) mit sich schräg zu einer Flächenerstreckung der Leiterplatte (20) erstreckender Motorwelle (21a, 21c) auf der Leiterplatte (20) befestigt ist, **dadurch gekennzeichnet, dass** der Elektromotor (22a, 22c) von hinten in das Halterungselement (23a, 23c) einsetzbar ist.

2. Halterungselement (23a, 23c) nach Anspruch 1, **dadurch gekennzeichnet, dass** die ersten Befestigungsmittel (24a, 24c) derart ausgebildet sind, dass sie eine Befestigung des Halterungselements (23a, 23c) auf der Leiterplatte (20) mittels eines Lötprozesses, insbesondere eines Reflow-Lötprozesses, erlauben.

3. Halterungselement (23a, 23c) nach Anspruch 1 oder 2, **dadurch gekennzeichnet, dass** die zweiten Befestigungsmittel (27a, 27c) derart ausgebildet sind, dass sie eine lösbare Befestigung des Elektromotors (22a, 22c) an dem Halterungselement (23a, 23c) erlauben.

4. Halterungselement (23a, 23c) nach Anspruch 3, **dadurch gekennzeichnet, dass** die zweiten Befestigungsmittel (27a, 27c) derart ausgebildet sind, dass sie eine Befestigung des Elektromotors (22a, 22c) an dem Halterungselement (23a, 23c) mittels einer Schnapp- oder Rastverbindung erlauben.

5. Halterungselement (23a, 23c) nach einem der Ansprüche 1 bis 4, **dadurch gekennzeichnet, dass** das Halterungselement (23a, 23c) Steck- oder Federkontaktelemente (26a, 26c) aufweist, die derart ausgebildet und angeordnet sind, dass sie bei an dem Halterungselement (23a, 23c) befestigtem Elektromotor (22a, 22c) mit korrespondierenden Steck- oder Federkontaktelementen (28a, 28c) des Elektromotors (22a, 22c) in Eingriff treten und für eine elektrische Kontaktierung des Elektromotors (22a, 22c) sorgen.

6. Halterungselement (23a, 23c) nach Anspruch 5, **dadurch gekennzeichnet, dass** die Steckkontaktelemente (26a, 26c) des Halterungselements (23a, 23c) Buchsenkontaktelemente sind, mit denen die als Stiftkontaktelemente ausgebildeten korrespondierenden Steckkontaktelemente (28a, 28c) des Elektromotors (22a, 22c) in Eingriff treten, wenn der Elektromotor (22a, 22c) an dem Halterungselement (23a, 23c) befestigt ist.

7. Halterungselement (23a, 23c) nach Anspruch 5 oder 6, **dadurch gekennzeichnet, dass** die Steck- oder Federkontaktelemente (26a, 26c) des Halterungselements (23a, 23c) bei auf der Leiterplatte (20) befestigtem Halterungselement (23a, 23c) mit entsprechenden Kontaktierungsmitteln (25a, 25c) auf der Leiterplatte (20) in Eingriff treten und für eine elektrische Kontaktierung der Steck- oder Federkontaktelemente (26a, 26c) des Halterungselements (23a, 23c) sorgen.

8. Halterungselement (23a, 23c) nach Anspruch 7, **dadurch gekennzeichnet, dass** die Kontaktierungsmittel (25a, 25c) der Leiterplatte (20) als Kontaktierungslöcher oder Kontaktierungsflächen ausgebildet sind, welche die Steck- oder Federkontaktelemente (26a, 26c) des Halterungselements (23a, 23c) bei auf der Leiterplatte (20) angeordnetem Halterungselement (23a, 23c) aufnehmen, so dass die Steck- oder Federkontaktelemente (26a, 26c) des Halterungselements (23a, 23c) mittels eines Lötprozesses, insbesondere eines Reflow-Lötprozesses, in den Kontaktierungslöchern (25a, 25c) oder auf den Kontaktierungsflächen der Leiterplatte (20) kontaktierbar und befestigbar sind.

9. Anzeigeeinrichtung (1; 10) eines Kraftfahrzeugs umfassend mindestens ein elektrisches Zeigerinstrument (3a, 3b, 3c, 3d, 3e, 13a, 13b, 13c) mit mindestens einem durch einen Elektromotor (22a, 22c) angetriebenen Zeiger (6a', 6a", 6b', 6b", 6c, 6d, 6e', 6e", 16a, 16c), wobei der Elektromotor (22a, 22c) auf einer elektronischen Leiterplatte (20) befestigt und über diese elektrisch kontaktiert ist und eine Motorwelle (21a, 21c) aufweist, an der der mindestens eine Zeiger (6a', 6a", 6b', 6b", 6c, 6d, 6e', 6e", 16a, 16c) des mindestens einen Zeigerinstruments (3a, 3b, 3c, 3d, 3e, 13a, 13b, 13c) befestigt ist, **dadurch gekennzeichnet, dass** der Elektromotor mittels eines Halterungselements (23a, 23c) derart auf der elektronischen Leiterplatte (20) befestigt ist, dass sich die Motorwelle (21a, 21c) schräg zu einer Flächenerstreckung der Leiterplatte (20) erstreckt.

10. Anzeigeeinrichtung nach Anspruch 9, **dadurch gekennzeichnet, dass** das Halterungselement (23a, 23c) separat von einem Gehäuse des Elektromotors (22a, 22c) ausgebildet ist

11. Anzeigeeinrichtung nach Anspruch 9 oder 10, **dadurch gekennzeichnet, dass** das Halterungselement (23a, 23c) nach einem der Ansprüche 2 bis 8 ausgebildet ist.

12. Verfahren zur Befestigung eines Elektromotors (22a, 22c) auf einer elektronischen Leiterplatte (20) eines elektrischen Zeigerinstruments (3a, 3b, 3c, 3d, 3e, 13a, 13b, 13c), wobei der Elektromotor (22a, 22c) über eine Motorwelle (21a, 21c) einen Zeiger (6a', 6a", 6b', 6b", 6c, 6d, 6e', 6e", 16a, 16c) des Zeigerinstruments (3a, 3b, 3c, 3d, 3e, 13a, 13b, 13c) antreibt, wobei zunächst ein Halterungselement (23a, 23c) über erste Befestigungsmittel (24a, 24c) des Halterungselements (23a, 23c) auf der Leiterplatte (20) befestigt wird und anschließend der Elektromotor (22a, 22c) über zweite Befestigungsmittel (27a, 27c) des Halterungselements an dem Halterungselement (23a, 23c) befestigt wird, wobei die ersten und zweiten Befestigungsmittel (24a, 24c; 27a, 27c) des Halterungselements (23a, 23c) derart ausgebildet und relativ zueinander angeordnet sind, dass der Elektromotor (22a, 22c) mit sich schräg zu einer Flächenerstreckung der Leiterplatte (20) erstreckender Motorwelle (21a, 21c) auf der Leiterplatte (20) befestigt wird, **dadurch gekennzeichnet, dass** der Elektromotor (22a, 22c) von hinten in das Halterungselement (23a, 23c) eingesetzt wird.

## Claims

1. A holder element (23a, 23c) for securing an electric motor (22a, 22c) to an electronic circuit board (20) of an electric display instrument (3a, 3b, 3c, 3d, 3e, 13a, 13b, 13c), wherein the electric motor (22a, 22c), via a motor shaft (21a, 21c), drives a pointer (6a', 6a", 6b', 6b", 6c, 6d, 6e', 6e", 16a, 16b, 16c) of the display instrument (3a, 3b, 3c, 3d, 3e, 13a, 13b, 13c), wherein the holder element (23a, 23c) has first securing means (24a, 24c) for securing the holder element (23a, 23c) to the circuit board (20) and second securing means (27a, 27c) for securing the electric motor (22a, 22c) to the holder element (23a, 23c), wherein the first and second securing means (24a, 24c; 27a, 27c) of the holder element (23a, 23c) are embodied and located relative to one another such that the electric motor (22a, 22c) is secured to the circuit board (20) with its motor shaft (21a, 21c) extending obliquely to an areal extent of the circuit board (20), **characterized in that** the electric motor (22a, 22c) is insertable from behind into the holder element (23a, 23c).

2. The holder element (23a, 23c) of claim 1, **characterized in that** the first securing means (24a, 24c) are embodied such that they permit securing the holder element (23a, 23c) to the circuit board (20) by means of a soldering process, in particular a reflow soldering process.

3. The holder element (23a, 23c) of claim 1 or 2, **characterized in that** the second securing means (27a, 27c) are embodied such that they permit releasable securing of the electric motor (22a, 22c) to the holder element (23a, 23c).

4. The holder element (23a, 23c) of claim 3, **characterized in that** the second securing means (27a, 27c) are embodied such that they permit securing the electric motor (22a, 22c) to the holder element (23a, 23c) by means of a snap connection or detent connection.

5. The holder element (23a, 23c) of one of claims 1 through 4, **characterized in that** the holder element (23a, 23c) has plug or spring contact elements (26a, 26c), which are embodied and located such that when the electric motor (22a, 22c) is secured to the holder element (23a, 23c), corresponding plug or spring contact elements (28a, 28c) of the electric motor (22a, 22c) enter into engagement and ensure electrical contacting of the electric motor (22a, 22c).

6. The holder element (23a, 23c) of claim 5, **characterized in that** the plug contact elements (26a, 26c) of the holder element (23a, 23c) are female contact elements, with which the plug contact elements (28a, 28c) of the electric motor (22a, 22c) that are embodied as pin contact elements enter into engagement when the electric motor (22a, 22c) is secured to the holder element (23a, 23c).

7. The holder element (23a, 23c) of claim 5 or 6, **characterized in that** the plug or spring contact elements (26a, 26c) of the holder element (23a, 23c), when the holder element (23a, 23c) is secured to the circuit board (20), enter into engagement with corresponding contacting means (25a, 25c) on the circuit board (20) and ensure an electrical contacting of the plug or spring contact elements (26a, 26c) of the holder element (23a, 23c).

8. The holder element (23a, 23c) of claim 7, **characterized in that** the contacting means (25a, 25c) of the circuit board (20) are embodied as contacting holes or contacting surfaces, which receive the plug or spring contact elements (26a, 26c) of the holder element (23a, 23c) when the holder element (23a, 23c) is located on the circuit board (20), so that the plug or spring contact elements (26a, 26c) of the holder element (23a, 23c) are contactable and securable in the contacting holes (25a, 25c) or on the contacting faces of the circuit board (20), by means of a soldering process, in particular a reflow soldering process.

9. A gauge arrangement (1; 10) of a motor vehicle, including at least one electric display instrument (3a, 3b, 3c, 3d, 3e, 13a, 13b, 13c) with at least one pointer (6a', 6a", 6b', 6b", 6c, 6d, 6e', 6e", 16a, 16b, 16c) driven by an electric motor (22a, 22c), wherein the electric motor (22a, 22c) is secured on an electronic circuit board (20) and contacted electrically by way of it and has a motor shaft (21a, 21c), to which the at least one pointer (6a', 6a", 6b', 6b", 6c, 6d, 6e', 6e", 16a, 16b, 16c) of the at least one display instrument (3a, 3b, 3c, 3d, 3e, 13a, 13b, 13c), is secured, **characterized in that** the electric motor is secured by means of a holder element (23a, 23c) on the electronic circuit board (20) in such a way that the motor shaft (21a, 21c) extends obliquely to an areal extent of the circuit board (20).

10. The gauge arrangement of claim 9, **characterized in that** the holder element (23a, 23c) is embodied separately from a housing of the electric motor (22a, 22c).

11. The gauge arrangement of claim 9 or 10, **characterized in that** the holder element (23a, 23c) is embodied in accordance with one of claims 2 through 8.

12. A method for securing an electric motor (22a, 22c) to an electronic circuit board (20) of an electric display instrument (3a, 3b, 3c, 3d, 3e, 13a, 13b, 13c), wherein the electric motor (22a, 22c), via a motor shaft (21a, 21c), drives a pointer (6a', 6a", 6b', 6b", 6c, 6d, 6e', 6e", 16a, 16b, 16c) of the display instrument (3a, 3b, 3c, 3d, 3e, 13a, 13b, 13c), wherein a holder element (23a, 23c) is first secured to the circuit board (20) via first securing means (24a, 24c) of the holder element (23a, 23c) and then the electric motor (22a, 22c) is secured via second securing means (27a, 27c) of the holder element to the holder element (23a, 23c), wherein the first and second securing means (24a, 24c; 27a, 27c) of the holder element (23a, 23c) are embodied and located relative to one another such that the electric motor (22a, 22c) is secured to the circuit board (20) with its motor shaft (21a, 21c) extending obliquely to an areal extent of the circuit board (20), **characterized in that** the electric motor (22a, 22c) is inserted from behind into the holder element (23a, 23c).

## Revendications

1. Élément de fixation (23a, 23c) pour la fixation d'un moteur électrique (22a, 22c) sur une plaquette de circuits imprimés électronique (20) d'un instrument électrique à aiguille (3a, 3b, 3c, 3d, 3e, 13a, 13b, 13c), où le moteur électrique (22a, 22c) entraîne, par l'intermédiaire d'un arbre moteur (21a, 21c), une aiguille (6a', 6a", 6b', 6b", 6c , 6d, 6e', 6e", 16a, 16c) de l'instrument à aiguille (3a, 3b, 3c, 3d, 3e, 13a, 13b, 13c), l'élément de fixation (23a, 23c) comportant des premiers moyens de fixation (24a, 24c) pour la fixation de l'élément de fixation (23a, 23c) sur la plaquette de circuits imprimés (20), et des seconds moyens de fixation (27a, 27c) pour la fixation du moteur électrique (22a, 22c) sur l'élément de fixation (23a, 23c), les premiers et seconds moyens de fixation (24a, 24c; 27a, 27c) de l'élément de fixation (23a, 23c) étant conçus et disposés l'un par rapport à l'autre de façon telle que le moteur électrique (22a, 22c) est fixé sur la plaquette de circuits imprimés (20) avec l'arbre moteur (21a, 21c) s'étendant de manière oblique par rapport à une étendue de surface de la plaquette de circuits imprimés (20), **caractérisé en ce que** le moteur électrique (22a, 22c) peut être inséré par l'arrière dans l'élément de fixation (23a, 23c).

2. Élément de fixation (23a, 23c) selon la revendication 1, **caractérisé en ce que** les premiers moyens de fixation (24a, 24c) sont conçus de manière à permettre une fixation de l'élément de fixation (23a, 23c) sur la plaquette de circuits imprimés (20) par un procédé de brasage, en particulier un procédé de brasage par refusion.

3. Élément de fixation (23a, 23c) selon la revendication 1 ou 2, **caractérisé en ce que** les seconds moyens de fixation (27a, 27c) sont conçus de manière à permettre une fixation amovible du moteur électrique (22a, 22c) sur l'élément de fixation (23a, 23c).

4. Élément de fixation (23a, 23c) selon la revendication 3, **caractérisé en ce que** les seconds moyens de fixation (27a, 27c) sont conçus de manière à permettre une fixation du moteur électrique (22a, 22c) sur l'élément de fixation (23a, 23c) au moyen d'une liaison par enclenchement ou encliquetage.

5. Élément de fixation (23a, 23c) selon l'une des revendications 1 à 4, **caractérisé en ce que** l'élément de fixation (23a, 23c) présente des éléments de contact à fiches ou à ressort (26a, 26c) qui sont conçus et agencés de façon à venir en prise, lorsque le moteur électrique (22a, 22c) est fixé sur l'élément de fixation (23a, 23c), avec des éléments de contact à fiches ou à ressort (28a, 28c) correspondants du moteur électrique (22a, 22c) et à assurer une mise en contact électrique du moteur électrique (22a, 22c).

6. Élément de fixation (23a, 23c) selon la revendication 5, **caractérisé en ce que** les éléments de contact à fiches (26a, 26c) de l'élément de fixation (23a, 23c) sont des éléments de contact femelles dans lesquels s'engagent les éléments de contact à fiches (28a, 28c) correspondants du moteur électrique (22a, 22c) conçus sous forme d'éléments de contact mâles, lorsque le moteur électrique (22a, 22c) est fixé sur l'élément de fixation (23a, 23c).

7. Élément de fixation (23a, 23c) selon la revendication 5 ou 6, **caractérisé en ce que** les éléments de contact à fiches ou à ressort (26a, 26c) de l'élément de fixation (23a, 23c) viennent en prise, lorsque l'élément de fixation (23a, 23c) est fixé sur la plaquette de circuits imprimés (20), avec des moyens de mise en contact (25a, 25c) correspondants sur la plaquette de circuits imprimés (20), et assurent une mise en contact électrique des éléments de contact à fiches ou à ressort (26a, 26c) de l'élément de fixation (23a, 23c).

8. Élément de fixation (23a, 23c) selon la revendication 7, **caractérisé en ce que** les moyens de mise en contact (25a, 25c) de la plaquette de circuits imprimés (20) sont réalisés sous forme d'orifices de contact ou de surfaces de contact qui reçoivent les éléments de contact à fiches ou à ressort (26a, 26c) de l'élément de fixation (23a, 23c) lorsque l'élément de fixation (23a, 23c) est disposé sur la plaquette de circuits imprimés (20), de façon telle que les éléments de contact à fiches ou à ressort (26a, 26c) de l'élément de fixation (23a, 23c) peuvent être mis en contact ou fixés par un procédé de brasage, en particulier un procédé de brasage par refusion, dans les orifices de contact (25a, 25c) ou sur les surfaces de contact de la plaquette de circuits imprimés (20).

9. Dispositif d'affichage (1; 10) d'un véhicule à moteur, comprenant au moins un instrument électrique à aiguille (3a, 3b, 3c, 3d, 3e, 13a, 13b, 13c) pourvu d'au moins une aiguille (6a', 6a", 6b', 6b", 6c, 6d, 6e', 6e", 16a, 16c) entraînée par un moteur électrique (22a, 22c), le moteur électrique (22a, 22c) étant fixé sur une plaquette de circuits imprimés électronique (20) et mis en contact électriquement par l'intermédiaire de celle-ci, et comportant un arbre moteur (21a, 21c) sur lequel est fixée l'aiguille (6a', 6a", 6b', 6b", 6c, 6d, 6e', 6e'', 16a, 16c), au moins au nombre de une, de l'instrument à aiguille (3a, 3b, 3c, 3d, 3e, 13a, 13b, 13c), au moins au nombre de un, **caractérisé en ce que** le moteur électrique est fixé sur la plaquette de circuits imprimés électronique (20) au moyen d'un élément de fixation (23a, 23c) de telle sorte que l'arbre moteur (21a, 21c) s'étend obliquement par rapport à une étendue de la surface de la plaquette de circuits imprimés (20).

10. Dispositif d'affichage selon la revendication 9, **caractérisé en ce que** l'élément de fixation (23a, 23c) est réalisé séparément d'un boîtier du moteur électrique (22a, 22c).

11. Dispositif d'affichage selon la revendication 9 ou 10, **caractérisé en ce que** l'élément de fixation (23a, 23c) est exécuté selon l'une des revendications 2 à 8.

12. Procédé de fixation d'un moteur électrique (22a, 22c) sur une plaquette de circuits imprimés électronique (20) d'un instrument électrique à aiguille (3a, 3b, 3c, 3d, 3e, 13a, 13b, 13c), dans lequel le moteur électrique (22a, 22c) entraîne, par l'intermédiaire d'un arbre moteur (21a, 21c), une aiguille (6a', 6a", 6b', 6b", 6c, 6d, 6e', 6e", 16a, 16c) de l'instrument à aiguille (3a, 3b, 3c, 3d, 3e, 13a, 13b, 13c), et dans lequel, tout d'abord, un élément de fixation (23a, 23c) est fixé sur la plaquette de circuits imprimés (20) par l'intermédiaire de premiers moyens de fixation (24a, 24c) de l'élément de fixation (23a, 23c) puis le moteur électrique (22a, 22c) est fixé, par l'intermédiaire de seconds moyens de fixation (27a, 27c) de l'élément de fixation, sur l'élément de fixation (23a, 23c), les premiers et seconds moyens de fixation (24a, 24c; 27a, 27c) de l'élément de fixation (23a, 23c) étant conçus et agencés l'un par rapport à l'autre de façon telle que le moteur électrique (22a, 22c) est fixé sur la plaquette de circuits imprimés (20) avec l'arbre moteur (21a, 21c) s'étendant de manière oblique par rapport à une étendue de surface de la plaquette de circuits imprimés (20), **caractérisé en ce que** le moteur électrique (22a, 22c) est inséré par l'arrière dans l'élément de fixation (23a, 23c).
